# EUROPEAN PATENT APPLICATION

(11) **EP 2 509 400 A1**
(43) Date of publication of application: **10.10.2012**
(21) Application number: 10834332.8
(22) Date of filing: 22.06.2010
(51) Int. Cl.: H05K 3/32, H01B 5/16, H01L 21/60, H01L 31/04

(54) **METHOD FOR MANUFACTURING ELECTRONIC COMPONENT, ELECTRONIC COMPONENT AND CONDUCTIVE FILM**

(30) Priority: 01.12.2009 JP 2009273998
(71) Applicant: Sony Chemical & Information Device Corporation, Tokyo 141-0032 (JP)
(72) Inventor: OKUMIYA, Hideaki, Kanuma-shi Tochigi 322-8503 (JP); SUGA, Yasuhiro, Kanuma-shi Tochigi 322-8503 (JP)
(74) Representative: Michalski Hüttermann & Partner
(86) International application number: PCT/JP2010/004144
(87) International publication number: WO 2011/067875

(57) **Abstract**

Provided is a method for manufacturing an electronic component using a conductive film formed by layering an adhesive layer and a release layer. The method for manufacturing the electronic component having a wiring includes: disposing an adhesive film formed by layering an adhesive layer and a release layer above a substrate having a surface on which a wiring is formed, such that the adhesive layer faces the surface; cutting the adhesive layer by inserting the wiring into the adhesive layer by depressing the adhesive film to the substrate; separating one adhesive layer portion of the cut adhesive layer from the surface; and releasing the release layer from the other adhesive layer portion of the cut adhesive layer.

## Description

### BACKGROUND

### TECHNICAL FIELD

The present invention relates to a method for manufacturing an electronic component, an electronic component, and a conductive film.

### RELATED ART

Anisotropic conductive adhesive films formed by layering a conductive layer and a release layer, etc., are used for connection of electronic components. When coating an anisotropic conductive adhesive film to an electronic component, first, a slit is cut into the conductive layer of the anisotropic conductive adhesive film while attention is paid so as not to cut the release layer.

Then, after the anisotropic conductive adhesive film and the electronic component are pressure-bonded, the release layer is released Alternatively, after a slit is cut into the conductive layer during pressure bonding by using a special jig, the release layer is released (See Patent Document 1 and Patent Document 2.)
(Patent Document 1)
   Japanese Patent Application Publication No. 2005-327922
(Patent Document 2)
   Japanese Patent Application Publication No. 2008-135652

### SUMMARY

### PROBLEM TO BE SOLVED BY THE INVENTION

When cutting a slit into the conductive layer of the conductive film, the slit might also reach into the release layer. Therefore, it is an object of an aspect of the innovations herein to provide a method for manufacturing an electronic component, an electronic component, and a conductive film which are capable of overcoming the above drawbacks accompanying the related art. The above and other objects can be achieved by combinations described in the main claim. The sub claims define further advantageous examples of the innovations herein.

### MEANS FOR SOLVING THE PROBLEM

To overcome the above drawbacks, a first aspect of the innovations may include a method for manufacturing an electronic component having a wiring, comprising: disposing an adhesive film, which is formed by layering an adhesive layer and a release layer, above a substrate having a surface on which the wiring is formed, such that the adhesive layer faces the surface; cutting the adhesive layer by inserting the wiring into the adhesive layer by depressing the adhesive film to the substrate; separating one adhesive layer portion of the cut adhesive layer from the surface; and releasing the release layer from the other adhesive layer portion of the cut adhesive layer.

In the above manufacturing method, the cutting may include heating the other adhesive layer portion. In the above manufacturing method, the cutting may include heating a vicinity of a region of the adhesive layer that contacts the wiring.

In the above manufacturing method, the electronic component may be a solar battery module including a photoelectric conversion member that generates photo-generated carriers by receiving incident light, and the wiring may be a finger electrode that collects the photo-generated carriers generated by the photoelectric conversion member. The above manufacturing method may further comprise electrically connecting a tab line and the finger electrode by bonding the tab line to the other adhesive layer portion from which the release layer has been released.

A second aspect of the innovations may include a method for coating an adhesive layer, comprising: disposing an adhesive film, which is formed by layering the adhesive layer and a release layer, above a substrate having a surface on which a wiring is formed, such that the adhesive layer faces the surface; cutting the adhesive layer by inserting the wiring into the adhesive layer by depressing the adhesive film to the substrate; separating one adhesive layer portion of the cut adhesive layer from the surface; and releasing the release layer from the other adhesive layer portion of the cut adhesive layer.

A third aspect of the innovations may include an electronic component, comprising: a substrate; a wiring formed on a surface of the substrate; and an adhesive layer coated on the surface, wherein the wiring is formed to have a height from the surface that is larger than a thickness of the adhesive layer, and the adhesive layer is cut by the wiring.

The above electronic component may comprise a plurality of wirings, wherein a first wiring of the plurality of wirings may be formed to have a height from the surface that is larger than a height of the rest of the plurality of wirings, and the adhesive layer may be coated at one side surface of the first wiring, and needs not be coated at the other side surface of the first wiring. The electronic component may be a solar battery module. The substrate may include a photoelectric conversion member which generates photo-generated carriers by receiving incident light. The plurality of wirings may be a plurality of finger electrodes which collect the photo-generated carriers generated by the photoelectric conversion members. The adhesive layer may contact at least a portion of each of the plurality of finger electrodes.

A fourth aspect of the innovations may include a conductive film formed by layering a conductive layer and a release layer, wherein the conductive layer contains a thermal-curing resin and conductive particles, and softens at a temperature between 30 °C and 180 °C and thermally cures at a temperature equal to or higher than 60 °C, and the conductive film is disposed above a substrate having a surface on which a wiring having a height larger than a thickness of the conductive layer is formed, such that the conductive film straddles the wiring, at least a portion of the conductive layer is softened by being heated, the conductive layer having been softened is cut by letting the wiring be inserted thereinto, one conductive layer portion of the cut conductive layer is separated from the surface, the release layer is released from the other conductive layer portion of the cut conductive layer, and the other conductive layer portion is coated on the surface of the substrate by the other conductive layer portion being thermally cured.

The summary clause does not necessarily describe all necessary features of the embodiments of the present invention. The present invention may also be a sub-combination of the features described above.

### BRIEF DESCRIPTION OF THE DRAWINGS

Fig. 1 schematically shows an example of a disposing step of disposing a conductive film 120 so as to face a solar battery cell 110.
Fig. 2 schematically shows an example of a cutting step of cutting a conductive layer 130.
Fig. 3 schematically shows an example of a separating step of separating a non-pressure-bonded region 210 of the conductive layer 130 from the solar battery cell 110.
Fig. 4 schematically shows an example of a releasing step of releasing a release layer 140 from a pressure-bonded region 220 of the conductive layer 130.
Fig. 5 schematically shows an example of an electrically connecting step of electrically connecting a tub line 518 and a finger electrode 116.
Fig. 6 schematically shows an example of a plan view of a solar battery module 600.
Fig. 7 schematically shows an example of an enlarged view of a region A of the solar battery module 600.
Fig. 8 schematically shows another example of an enlarged view of the region A of the solar battery module 600.
Fig. 9 schematically shows another example of an enlarged view of the region A of the solar battery module 600.
Fig. 10 schematically shows another example of an enlarged view of the region A of the solar battery module 600.
Fig. 11 schematically shows another example of an enlarged view of the region A of the solar battery module 600.
Fig. 12 schematically shows another example of an enlarged view of the region A of the solar battery module 600.
Fig. 13 schematically shows an example of a plan view of a backing material 1300.
Fig. 14 schematically shows an example of a plan view showing a positional relationship among the backing material 1300, a conductive film 1420, and a heater head 1460.

### DESCRIPTION OF EXEMPLARY EMBODIMENTS

Hereinafter, some embodiments of the present invention will be described. The embodiments do not limit the invention according to the claims, and all the combinations of the features described in the embodiments are not necessarily essential to means available from aspects of the invention.

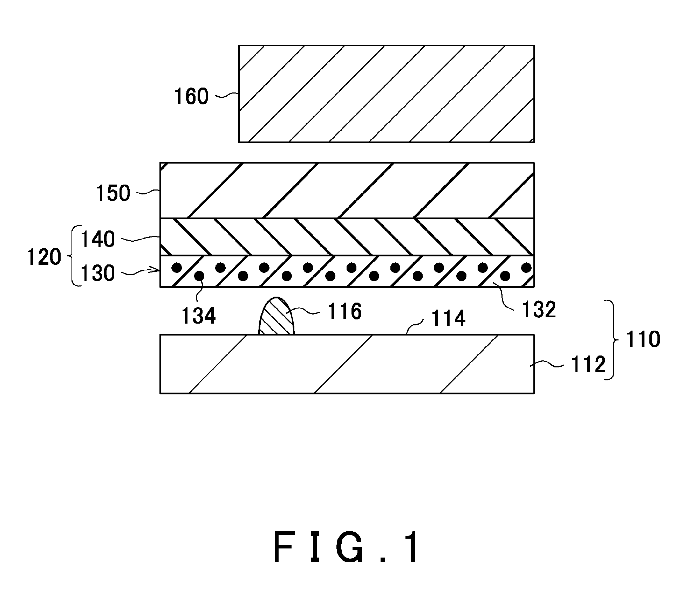

Fig. 1 to Fig. 5 schematically show an example of a process for forming a tab line on a surface of a solar battery cell 110. Fig. 1 schematically shows an example of a disposing step of disposing a conductive film 120 so as to face the solar battery cell 110. The conductive film 120 may be an anisotropic conductive adhesive film. The conductive film 120 may be an example of an adhesive film.

In the disposing step shown in Fig. 1, the conductive film 120, which is formed by layering a conductive layer 130 and a release layer 140, is disposed between the solar battery cell 110 and a heater head 160. In the conductive film 120, the conductive layer 130 is disposed to face a light incidence surface 114 of the solar battery cell 110. A buffering member 150 is disposed between the conductive film 120 and the heater head 160. The conductive layer 130 may be an example of an adhesive layer.

The solar battery cell 110 includes a photoelectric conversion member 112 and a finger electrode 116. The finger electrode 116 may be a part of a pair of electrodes which are formed on the light incidence surface 114 and a back surface of the photoelectric conversion member 112 in order to acquire an output from the photoelectric conversion member 112. The solar battery cell 110 and the photoelectric conversion member 112 may be an example of a substrate. The finger electrode 116 may be an example of a wiring.

Of the pair of electrodes provided on the light incidence surface 114 and back surface of the photoelectric conversion member 112, the electrode provided on the light incidence surface 114 of the photoelectric conversion member 112 may be formed in a comb shape by combining a plurality of narrow electrodes with a broad electrode for electrically connecting the plurality of narrow electrodes. This allows for making the area by which light incidence is shielded as small as possible. The narrow electrodes may be referred to as finger electrodes, and the broad electrode may be referred to as a bus bar electrode. Of the pair of electrodes, the electrode provided on the back surface of the photoelectric conversion member 112 may be formed to cover substantially the entire back surface of the photoelectric conversion member 112, and may be formed in a comb shape like the electrode on the light incidence surface 114.

The photoelectric conversion member 112 generates photo-generated carriers by letting light enter there. The photoelectric conversion member 112 can be manufactured by, for example, layering a first ITO film, an n-type amorphous silicon layer, an i-type amorphous silicon layer, an n-type mono-crystal silicon substrate, an i-type amorphous silicon layer, a p-type amorphous silicon layer, and a second ITO film in this order.

The finger electrode 116 collects the photo-generated carriers generated by the photoelectric conversion member 112. The finger electrode 116 can be formed by, for example, using a thermal-curing conductive paste containing an epoxy resin as a binder and silver powder, silver particles, etc. as a filler.

The height of the finger electrode 116 from the light incidence surface 114 of the solar battery cell 110 may be larger than the thickness of the conductive layer 130. Though Fig. 1 shows a case where one finger electrode 116 is provided in order to simplify the explanation, a plurality of finger electrodes 116 may be provided on the light incidence surface 114.

The conductive layer 130 may have an anisotropic nature. For example, the conductive layer 130 contains a thermal-curing resin 132 and particles 134. Hence, when members to be electrically connected are heated and pressurized with the conductive layer 130 interposed between them, a conduction path is formed at a portion to which the pressure is applied, thereby electrically connecting the members. Meanwhile, a portion to which no pressure is applied is kept insulated, thereby preventing a short circuit between any adjacent members disposed above the conductive layer 130.

The thermal-curing resin 132 bonds the members to be electrically connected. The thermal-curing resin 132 softens or melts by being heated or pressurized. This allows the space between the members to be electrically connected to be filled with the thermal-curing resin 132. Because having a thermal-curing property, the thermal-curing resin 132 starts a curing reaction and becomes solidified when heated to a temperature equal to or higher than a curing start temperature of a curing agent. In this way, the thermal-curing resin 132 bonds the members to be electrically connected. The thermal-curing resin 132 keeps the particles 134 cohered by its cure shrinkage force.

The thermal-curing resin 132 may be a thermal-curing resin such as epoxy resin, acrylic resin, etc. The thermal-curing resin 132 may be a thermal-curing resin having an insulating property. The thermal-curing resin 132 may be a thermal-curing resin which softens at a temperature between 30 °C and 180 °C, and thermally cures at a temperature equal to or higher than 60 °C. The thickness of the thermal-curing resin 132 may be 10 to 50 µm.

The particles 134 are dispersed in the thermal-curing resin 132 when the conductive layer 130 is not pressurized. When the conductive layer 130 is pressurized, the particles 134 dispersed in the thermal-curing resin 132 contact and lap each other, and form a conduction path in the pressurizing direction by being pushed into contact with each other.

The particles 134 may have a spherical shape having a size of a few µm. The particles 134 may have a scurf shape having a longer diameter of 1 to 20 µm, a thickness of 3 µm or smaller, and an aspect ratio of 3 to 50. The particles 134 may be conductive particles such as metal particles, etc., or resin particles or metal particles plated with gold. The particles 134 may further have an insulation layer formed on the plated gold. Metal particles may be Ni particles.

The release layer 140 prevents a portion of the conductive layer 130 from adhering to another portion thereof when the conductive film 120 is rolled up like a reel. Rolling up the conductive film 120 makes the conductive film 120 easier to carry around. When coating the conductive layer 130 onto the photoelectric conversion member 112 by using a pressure-bonding device, the release layer 140 prevents the conductive layer 130 from adhering to the pressure-bonding device. Furthermore, the release layer 140 can prevent any foreign matter from mixing into the conductive film 120. The release layer 140 may be formed of a plastic material such as a polyester film, a polyethylene terephthalate film, etc., or paper such as high-quality paper, glassine paper, etc. The release layer 140 may be surface-finished by a silicone treatment.

The conductive film 120 can be manufactured by the following procedure, for example. First, 10 parts by mass of conductive particles, 50 parts by mass of bisphenol A-type epoxy resin (EP828, available from Japan Epoxy Resin Co., Ltd.), 20 parts by mass of phenoxy resin (YP-50, available from Tohto Kasei Co., Ltd.), 20 parts by mass of imidazole latent hardener (HX3941HP, available from Asahi Kasei Corporation), and 100 parts by mass of toluene are mixed to prepare a conductive adhesive composition. The conductive particles have a scurf shape having a longer diameter of 1 to 20 µm, a thickness of 3 µm or smaller, and an aspect ratio of 3 to 50, and may contain 50 percent by mass or higher of Ni particles having a Mohs hardness of 3.8.

Next, the obtained conductive adhesive composition is applied over a polyethylene terephthalate film having a thickness of 50 µm. The polyethylene terephthalate film may be one that is surface-finished by a release treatment. The conductive adhesive composition may be applied to a thickness of approximately 25 µm. The conductive adhesive composition applied over the polyethylene terephthalate film is grown to a film by a heating/drying process carried out in an oven set to 80 °C for 5 minutes. In this way, the conductive film 120 is obtained.

The conductive film 120 can also be manufactured by the following procedure. First, 10 parts by mass of conductive particles, 50 parts by mass of difunctional acrylate monomer (A-200, available from Shin-Nakamura Chemical Co., Ltd.), 20 parts by mass of phenoxy resin (YP-50, available from Tohto Kasei Co., Ltd.), 20 parts by mass of organic peroxide curing agent (benzoyl peroxide, available from NOF Corporation), and 100 parts by mass of toluene are mixed to prepare a conductive adhesive composition. The conductive particles have a scurf shape having a longer diameter of 1 to 20 µm, a thickness of 3 µm or smaller, and an aspect ratio of 3 to 50, and may contain 50 percent by mass or higher of Ni particles having a Mohs hardness of 3.8.

Next, the obtained conductive adhesive composition is applied over a polyethylene terephthalate film having a thickness of 50 µm. The polyethylene terephthalate film may be one that is surface-finished by a release process. The conductive adhesive composition may be applied to a thickness of approximately 25 µm. The conductive adhesive composition applied over the polyethylene terephthalate film is grown to a film by a heating/drying process carried out in an oven set to 80 °C for 5 minutes. In this way, the conductive film 120 is obtained.

The buffering member 150 is disposed between the heater head 160 and the conductive film 120. This allows for pressurizing the conductive film 120 more uniformly than when no buffering member 150 is provided. The buffering member 150 may be an elastomer such as a silicone rubber.

The heater head 160 is used for heating and pressurizing the conductive film 120 via the buffering member 150. The heater head 160 may have elastomers where it performs pressure-bonding of electronic components, etc. This allows for more uniform pressurizing even when pressure-bonding electronic components having different heights.

In the present embodiment, an application has been described in which the solar battery cell 110 or the photoelectric conversion member 112 is used as the substrate to which the conductive layer 130 is to be coated. However, the substrate is not limited to this. The solar battery cell 110 may be formed on a portion of the substrate to which the conductive layer 130 is to be coated. Furthermore, the substrate may be a printed wiring board, a glass substrate, a semiconductor substrate, or a ceramic substrate.

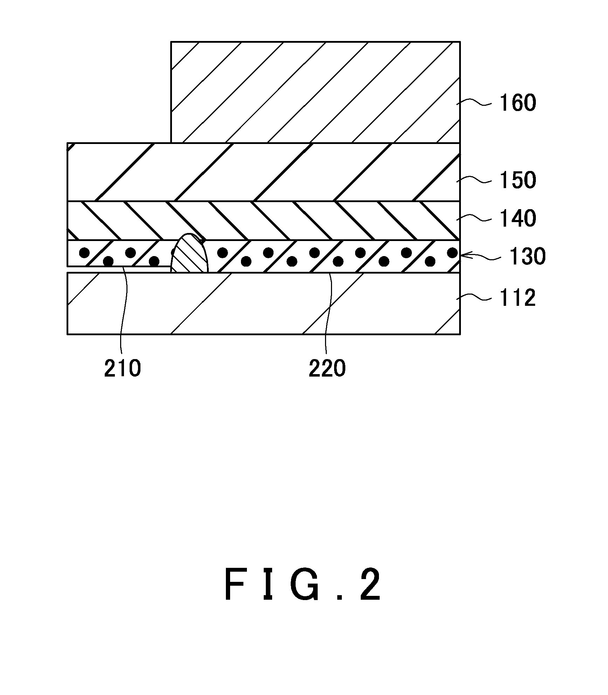

Fig. 2 schematically shows an example of a cutting step of cutting the conductive layer 130. In the cutting step shown in Fig. 2, after the conductive film 120 is disposed so as to straddle the finger electrode 116, the heater head 160 depresses the conductive film 120 to the solar battery cell 110 via the buffering member 150. This causes the finger electrode 116 to be inserted into the conductive layer 130, thereby cutting the conductive layer 130 into a non-pressure-bonded region 210 and a pressure-bonded region 220.

It is preferred that the heater head 160 depress the conductive film 120 to the solar battery cell 110 at a pressure of 0.3 to 3.0 MPa, and more preferably at a pressure of 0.5 to 2.5 MPa. If the pressure is lower than 0.3 MPa, sufficient pressure-bonding might not be obtained. If the pressure is higher than 3.0 MPa, circuit member electrodes, a backing material, etc. might be broken.

The cutting step shown in Fig. 2 may include a heating step of the heater head 160 heating the conductive film 120. In the heating step, by heating and pressurizing the conductive film 120, the heater head 160 can preliminarily pressure-bond the conductive layer 130 to the solar battery cell 110.

The heating temperature in the preliminary pressure-bonding may be lower than the heating temperature in the substantive pressure-bonding of bonding, by the conductive layer 130, members to be electrically connected. For example, it is preferable to heat the conductive layer 130 to a temperature of 40 to 90 °C in the heating step. If the heating temperature is lower than 40 °C, a favorable preliminary pressure-bonding might not be obtained. If the heating temperature is higher than 90 °C, the conductive layer 130 might stiffen, making it difficult to obtain favorable circuit connection in the later substantive pressure-bonding step. The heating and pressurizing time may be 0.3 to 10 seconds.

In the heating step, the heater head 160 may heat the pressure-bonded region 220 of the conductive layer 130. This allows the pressure-bonded region 220 of the conductive layer 130 to be preliminarily pressure-bonded to the solar battery cell 110 while preventing the non-pressure-bonded region 210 of the conductive layer 130 from being preliminarily pressure-bonded to the solar battery cell 110.

In the heating step, the heater head 160 may heat the vicinity of a region of the conductive layer 130 that abuts on the finger electrode 116. This causes the finger electrode 116 to be inserted into the conductive layer 130 that is softening, allowing the conductive layer 130 to be cut easily.

In Fig. 2, in order to simplify the explanation, the non-pressure-bonded region 210 is depicted to seem like floating from the light incidence surface 114 of the solar battery cell 110. However, the cutting step is not limited to this. In the cutting step, the non-pressure-bonded region 210 may result in contacting the solar battery cell 110, or a region of the non-pressure-bonded region 210 that abuts on the finger electrode 116 may result in being preliminarily pressure-bonded to the solar battery cell 110.

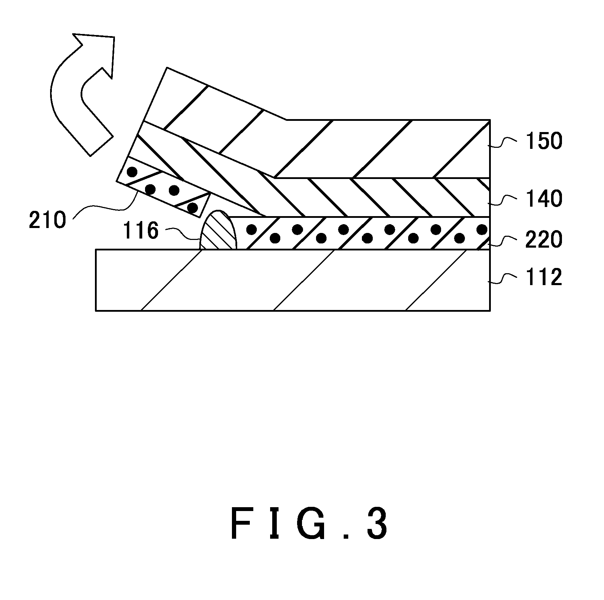

Fig. 3 schematically shows an example of a separating step of separating the non-pressure-bonded region 210 of the conductive layer 130 from the solar battery cell 110. In the separating step shown in Fig. 3, the non-pressure-bonded region 210 of the cut conductive layer 130 is not pressure-bonded to the solar battery cell 110, or even if it is pressure-bonded thereto, the adhesion between the non-pressure-bonded region 210 and the release layer 140 is stronger than the adhesion between the non-pressure-bonded region 210 and the solar battery cell 110. Therefore, it is possible to separate the non-pressure-bonded region 210 of the conductive layer 130 from the light incidence surface 114 of the solar battery cell 110 by picking up a portion of the release layer 140 that is above the non-pressure-bonded region 210.

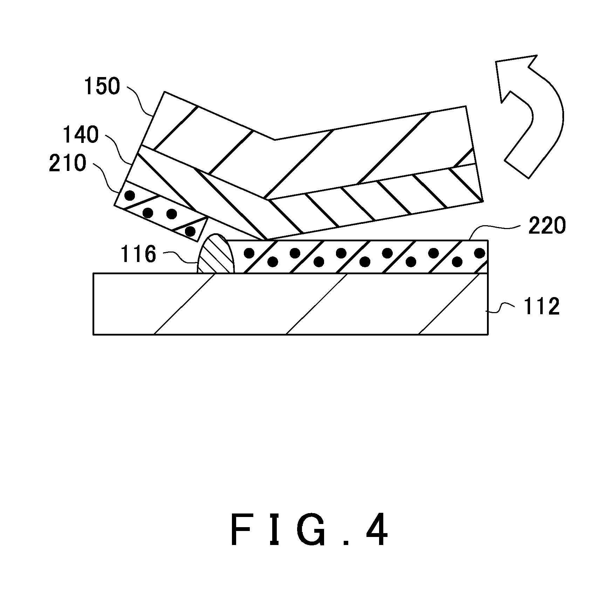

Fig. 4 schematically shows an example of a releasing step of releasing the release layer 140 from the pressure-bonded region 220 of the conductive layer 130. In the releasing step shown in Fig. 4, the pressure-bonded region 220 of the cut conductive layer 130 is pressure-bonded to the solar battery cell 110, and the adhesion between the pressure-bonded region 220 and the solar battery cell 110 is stronger than the adhesion between the pressure-bonded region 220 and the release layer 140. Therefore, it is possible to release the release layer 140 from the pressure-bonded region 220 of the conductive layer 130, by, for example, picking up a portion of the release layer 140 that is above the pressure-bonded region 220.

Through the steps described above, the conductive layer 130 can be coated onto the solar battery cell 110. In the present embodiment, the conductive layer 130 is coated at one side surface of the finger electrode 116 (at the right-hand side of the finger electrode 116 in Fig. 4), and not at the other side surface of the finger electrode 116 (at the left-hand side of the finger electrode 116 in Fig. 4). Further, when the pressure-bonded region 220 coated on the solar battery cell 110 is heated and pressurized wholly, the pressure-bonded region 220 has a conductive property.

According to the steps described above, it is possible to coat a predetermined length of the conductive layer 130 onto the surface of the solar battery cell 110 even without cutting a slit into the conductive layer 130 in advance. This allows for preventing the release layer 140 from being cut inclusively even when the thickness of the release layer 140 is small.

Further, according to the steps described above, when coating the conductive layer 130 onto the surface of the solar battery cell 110, it is possible to coat a predetermined length of the conductive layer 130 on the surface of the solar battery cell 110 without applying a large pressure locally to a portion of the solar battery cell 110. Hence, when coating the conductive layer 130 onto the surface of the solar battery cell 110, it is possible to prevent the solar battery cell 110 from being broken.

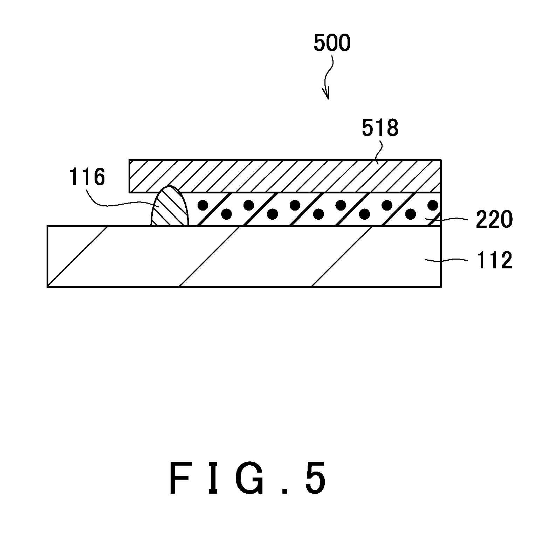

Fig. 5 schematically shows an example of an electrically connecting step of electrically connecting a tab line 518 and the finger electrode 116. In the electrically connecting step shown in Fig. 5, a tab line 518 is bonded to the pressure-bonded region 220 of the conductive layer 130 from which the release layer 140 has been released, to form the tab line 518 on the pressure-bonded region 220 of the conductive layer 130. This allows the tab line 518 to be electrically connected to the finger electrode 116. The tab line 518 may electrically connect the solar battery cell 110 to another solar battery cell. The tab line 518 may be a metal foil such as a copper foil, or a metal foil plated with solder, nickel, tin, etc.

In the electrically connecting step shown in Fig. 5, the solar battery cell 110 and the tab line 518 are substantively pressure-bonded. This allows the tab line 518 to be formed above the light incidence surface 114 of the solar battery cell 110. Further, the substantive pressure-bonding causes the tab line 518 to be electrically connected to the finger electrode 116. The tab line 518 and the finger electrode 116 may be electrically connected by themselves coming into contact with each other directly, or may be electrically connected through the particles 134 in the conductive layer 130.

For example, when the conductive layer 130 had softened from being heated when the finger electrode 116 was inserted into the conductive layer 130, the particles 134 of the conductive layer 130 are left on the finger electrode 116. Further, when the pressure-bonded region 220 coated on the solar battery cell 110 had been heated and pressurized wholly, the pressure-bonded region 220 has a conductive property. Hence, the tab line 518 and the finger electrode 116 are electrically connected through the particles 134 of the conductive layer 130.

The substantive pressure-bonding can be carried out by heating and pressurizing the pressure-bonded region 220 of the conductive layer 130 by using the heater head 160. In the substantive pressure-bonding, the heater head 160 may heat the conductive film 120 such that the temperature of the conductive layer 130 will become 150 to 200 °C. The heating and pressurizing time may be 5 to 30 seconds. The heater head 160 may depress the tab line 518 to the solar battery cell 110 at a pressure of 0.5 to 3.0 MPa. The heater head used for the substantive pressure-bonding and the heater head used for the preliminary pressure-bonding may be the same heater head, or may be different heater heads

Through the steps described above, a solar battery module 500 can be manufactured. The solar battery module may be one example of an electronic component. The solar battery module 500 includes the solar battery cell 110, the finger electrode 116 formed on the light incidence surface 114 of the solar battery cell 110, and the conductive layer 130 coated on the light incidence surface 114 and contacting at least a portion of the finger electrode 116. The solar battery module 500 may include a plurality of finger electrodes 116. The finger electrode 116 may be formed to have a height from the light incidence surface 114 that is larger than the height of the conductive layer 130. It is possible to also form a tab line on the back surface of the solar battery cell 110 by the same method.

In the solar battery module 500, the conductive layer 130 may be cut by the finger electrode 116. Of the plurality of finger electrodes 116, the finger electrode 116 to cut the conductive layer 130 may be formed to have a height from the light incidence surface 114 that is larger than the height of the other finger electrodes 116. In this case, the conductive layer 130 is coated at one side surface of the finger electrode 116 cutting the conductive layer 130, and needs not be coated at the other side surface thereof. The finger electrode 116 cutting the conductive layer 130 may be one example of a first wiring.

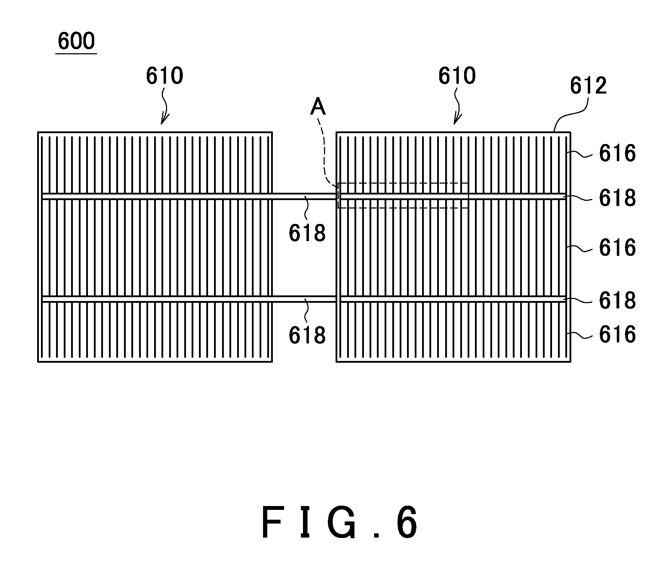

Fig. 6 schematically shows an example of a plan view of a solar battery module 600. The solar battery module 600 can be manufactured by connecting two solar battery cells 610 in series. The solar battery module 600 may be one example of an electronic component. In the present embodiment, tab lines 618 formed on the light incidence surface of the solar battery cell 610 on the left-hand side of the drawing are electrically connected to electrodes formed on the back surface of the solar battery cell 610 on the right-hand side of the drawing. However, the method of connecting the solar battery cells 610 is not limited to this. Tab lines 618 formed on the back surface of the solar battery cell 610 on the right-hand side of the drawing may be electrically connected to electrodes formed on the back surface of the solar battery cell 610 on the left-hand side of the drawing.

The solar battery cell 610 includes a photoelectric conversion member 612, finger electrodes 616, and tab lines 618. In the solar battery cell 610, a plurality of finger electrodes 616 are electrically connected to two tab lines 618. The solar battery cell 610 may have the same configuration as that of the solar battery cell 110. The photoelectric conversion member 612, the finger electrodes 616, and the tab lines 618 may each have the same configuration as that of the photoelectric conversion member 112, the finger electrode 116, and the tab line 518. The solar battery cell 610 and the photoelectric conversion member 612 may be examples of a substrate. The finger electrodes 616 may be an example of wirings.

In the following, explanation will be mainly given to any differences of the solar battery cell 610 and its constituent elements from the solar battery cell 110 and its constituent element, and redundant explanation may not be provided. The solar battery cell 110 and its constituent elements may have the same configuration as the described configuration of the solar battery cell 610 and its constituent elements.

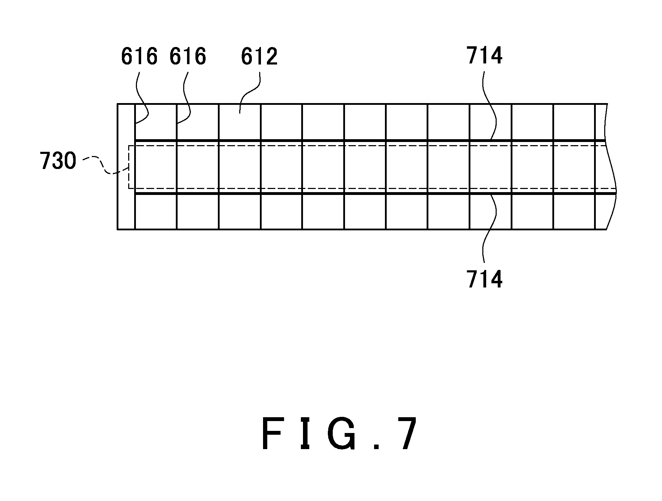

Fig. 7 to Fig. 12 schematically show an example of an enlarged view of a region A of the solar battery module 600. The method of electrically connecting the plurality of finger electrodes 616 of the solar battery cell 610 will be described by using Fig. 7 to Fig. 12. Note that Fig. 7 to Fig. 12 show no tab line 618 in order to simplify the explanation.

The solar battery cell 610 further includes a bus bar electrode 714 and a conductive layer 730. The conductive layer 730 may have the same configuration as that of the conductive layer 130. The conductive layer 730 may be an example of a conductive layer of a conductive film. The conductive layer 730 may be coated on the surface of the solar battery cell 610 by the method described in relation with Fig. 1 to Fig. 4.

The bus bar electrode 714 is electrically connected to the plurality of finger electrodes 616, and collects photo-generated carriers collected by the plurality of finger electrodes 616. The bus bar electrode 714 can be formed of a thermal-curing conductive paste containing an epoxy resin as a binder and silver powder, silver particles, etc. as a filler.

The conductive layer 730 is coated on the surface of the solar battery cell 610, and contacts at least a portion of each of the finger electrodes 616. The conductive layer 730 is disposed between the plurality of finger electrodes 616 and the tab line 618, and electrically connects them.

In the solar battery cell 610, the finger electrode 616 at the leftmost side of the drawing may be formed to have a height from the surface of the photoelectric conversion member 612 that is larger than the height of the other finger electrodes 616. This allows the conductive layer 730 to be cut easily.

The solar battery module 600 can be manufactured by the manufacturing method described in relation with Fig. 1 to Fig. 5. Hence, the solar battery module 600 including the solar battery cell 610, the finger electrodes 616 formed on the surface of the solar battery cell 610, and the conductive layer 730 coated on the surface of the solar battery cell 610 can be manufactured. In the solar battery module 600, the finger electrodes 616 may be formed to have a height from the surface of the solar battery cell 610 that is larger than the height of the conductive layer 730, so that the conductive layer 730 may be cut by the finger electrodes 616.

In Fig. 7, a plurality of finger electrodes 616 are electrically connected through two bus bar electrodes 714 and the conductive layer 730. The conductive layer 730 is disposed between the two bus bar electrodes 714. According to the present embodiment, the plurality of finger electrodes 616 and the tab line 618 are electrically connected through the conductive layer 730. This allows the layout of the bus bar electrodes 714 to be designed freely.

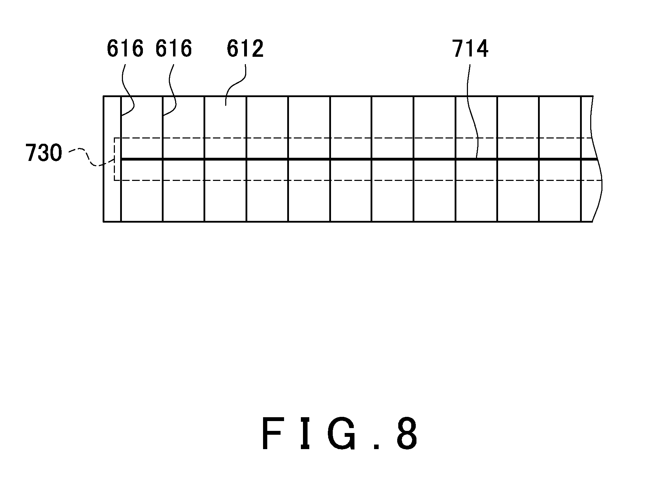

In Fig. 8, a plurality of finger electrodes 616 are electrically connected through one bus bar electrode 714 and the conductive layer 730. The conductive layer 730 is disposed so as to cover the bus bar electrode 714. According to the present embodiment, the width (in the up-down direction of the drawing) of the conductive layer 730 is larger than the width of the bus bar electrode 714. The plurality of finger electrodes 616 and the tab line 618 are electrically connected through the conductive layer 730.

This makes it possible to make any manufacturing error of the bus bar electrode 714 less influential than when a conductive layer 730 having a width similar to the width of the bus bar electrode 714 is coated on the bus bar electrode 714 and the bus bar electrode 714 and the tab line 618 are electrically connected through this conductive layer 730. As a result, it becomes possible to improve the yield of the solar battery module 600.

In a conventional solar battery module, a bus bar electrode and a finger electrode have similar heights, and the bus bar electrode has a width of some degree. Then, the bus bar electrode and the tab line are electrically connected by coating a conductive layer having a width similar to the width of the bus bar electrode on the bus bar electrode, and pasting a tab line on the conductive layer. Therefore, it has been difficult to improve the yield of the solar battery module. Furthermore, it has not been carried out to cut the conductive film by the bus bar electrode or the finger electrode.

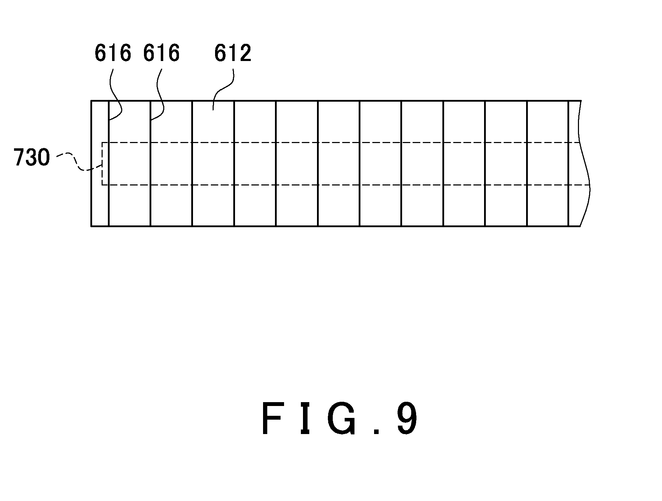

In Fig. 9, a plurality of finger electrodes 616 are electrically connected through the conductive layer 730. In the present embodiment, no bus bar electrode 714 is formed. Also in this case, the plurality of finger electrodes 616 and the tab line 618 are electrically connected through the conductive layer 730. Hence, it is possible to collect photo-generated carriers collected by the plurality of finger electrodes 616.

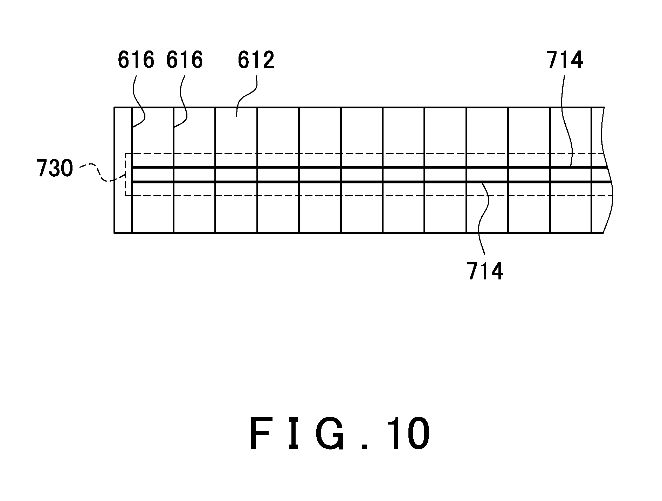

In Fig. 10, a plurality of finger electrodes 616 are electrically connected through two bus bar electrodes 714 and the conductive layer 730. The conductive layer 730 is disposed so as to cover the two bus bar electrodes 714. This allows for making any manufacturing error of the bus bar electrodes 714 less influential. Further, since the area by which the bus bar electrodes 714 and the conductive layer 730 are connected is increased, it is possible to obtain a more secure contact between the bus bar electrodes 714 and the conductive layer 730, enabling connection errors to be reduced. As a result, it becomes possible to further improve the yield of the solar battery module 600.

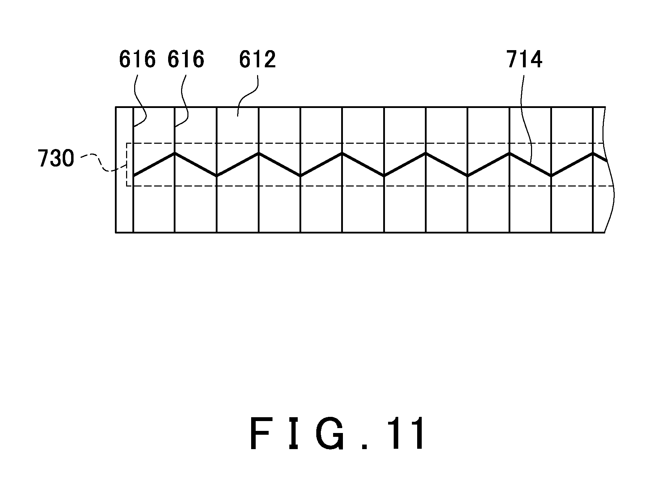

In Fig. 11, a plurality of fiber electrodes 616 are electrically connected through one bus bar electrode 714 and the conductive layer 730. The conductive layer 730 is disposed so as to cover the bus bar electrode 714. The bus bar electrode 714 is disposed in a switchback manner in the direction in which the conductive layer 730 extends (the left-right direction of the drawing). This allows the conductive layer 730 and the photoelectric conversion member 612 to be bonded more firmly than when the bus bar electrode 714 is disposed linearly in the direction in which the conductive layer 730 extends. Further, since the area by which the bus bar electrode 714 and the conductive layer 730 are connected is increased, it is possible to obtain a more secure contact between the bus bar electrode 714 and the conductive layer 730, enabling connection errors to be reduced. As a result, it becomes possible to further improve the yield of the solar battery module 600.

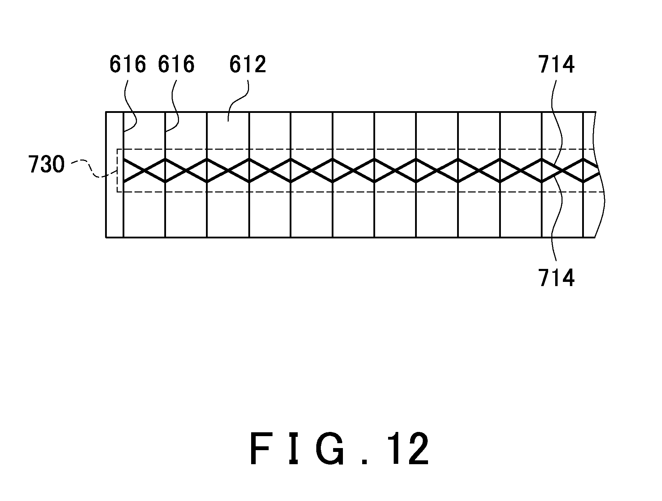

In Fig. 12, a plurality of finger electrodes 616 are electrically connected through two bus bar electrodes 714 and the conductive layer 730. The conductive layer 730 is disposed so as to cover the bus bar electrodes 714. The two bus bar electrodes 714 are disposed in a switchback manner in the direction in which the conductive layer 730 extends, and intersect each other. This allows the conductive layer 730 and the photoelectric conversion member 612 to be bonded more firmly than when the bus bar electrodes 714 are disposed linearly in the direction in which the conductive layer 730 extends. Further, since the area by which the bus bar electrodes 714 and the conductive layer 730 are connected is increased, it is possible to obtain a more secure contact between the bus bar electrodes 714 and the conductive layer 730, enabling connection errors to be reduced. As a result, it becomes possible to further improve the yield of the solar battery module 600.

### EXAMPLES

In accordance with the procedure described in relation with Fig. 1 to Fig. 4, a conductive layer of a conductive film was coated on a glass substrate having wirings. The coating of the conductive layer to the glass substrate was carried out for each of the cases among which the width of the wirings and the positional relationship between the heater head and the wirings were varied.

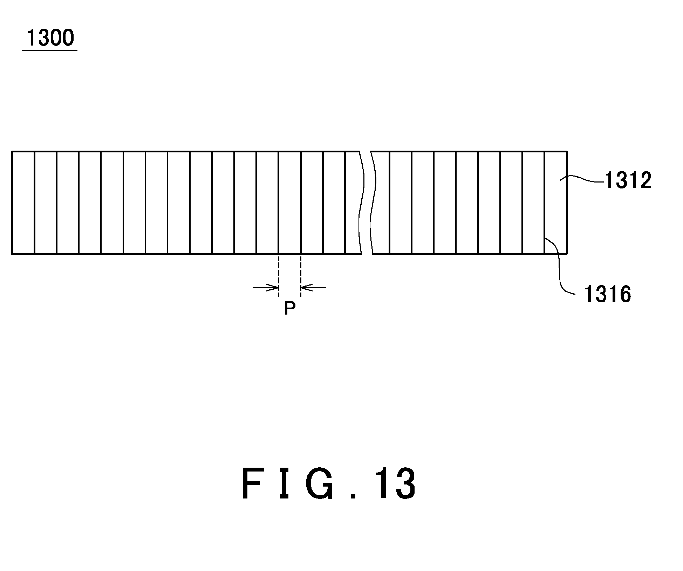

Fig. 13 schematically shows an example of a plan view of a backing material 1300 used in Example 1. The backing material 1300 includes a glass substrate 1312 and a plurality of wirings 1316. A glass substrate of which width (in the drawing, the left-right direction dimension may be called the width of the glass substrate 1312) was 80 mm, of which length (in the drawing, the up-down direction dimension may be called the length of the glass substrate 1312) was 15 mm, and of which thickness was 0.7 mm was used as the glass substrate 1312.

The plurality of wirings 1316 were arranged at equal intervals on the glass substrate 1312. The pitch P of the plurality of wirings 1316 was 3 mm. The plurality of wirings 1316 were manufactured by applying an Ag paste over the glass substrate 1312 by screen printing, and burning them.

The plurality of wirings 1316 were formed in substantially the same shape. Each of the wirings 1316 had a length (in the drawing, the up-down direction dimension may be called the length of the wirings 1316) of 15 mm, and a height of 50 µm. Coating of the conductive layer was carried out for the cases when the width of each wiring 1316 (in the drawing, the left-right direction dimension may be called the width of the wiring 1316) was 100 µm, and was 150 µm.

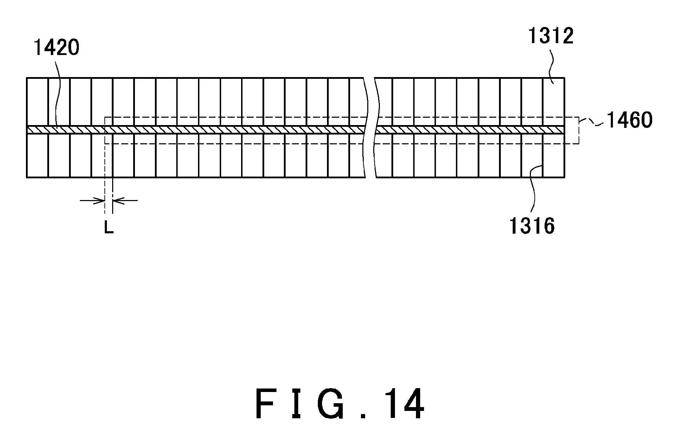

Fig. 14 schematically shows an example of a plan view showing the positional relationship among the backing material 1300, a conductive film 1420 and the heater head 1460. A conductive film CP9732KS available from Sony Chemical & Information Device Corporation was used as the conductive film 1420. The conductive film 1420 was one that had a width (in the drawing, the up-down direction dimension may be called the width of the conductive film 1420) of 2 mm.

The heater head 1460 was one that had a width (in the drawing, the up-down direction dimension may be called the width of the heater head 1460) of 4 mm. The heater head 1460 was disposed such that the widthwise center of the conductive film 1420 and the widthwise center of the heater head 1460 coincided. The heater head 1460 was disposed such that its one widthwise end was displaced from an end of the wiring 1316 by L in the widthwise direction. Coating of the conductive layer was carried out for the cases when L was 0.5 mm, and was 1 mm.

The temperature of the heater head 1460 was set to 90 °C. Pressurizing by the heater head 1460 was carried out at a pressure of 0.5 MPa for one second. At this time, the temperature of the conductive film 1420 was approximately 80 °C. A silicone rubber having a thickness of 200 µm was used as the buffering member.

Coating of the conductive film 1420 to the backing material 1300 was carried out by varying the width of the wirings 1316 and the value of L as described above. As a result, regardless of the width of the wirings 1316 and the value of L, it was possible in all of the cases to coat the conductive layer of the conductive film 1420 on the surface of the backing material 1300 without cutting a slit into the conductive layer of the conductive film 1420 in advance.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCE NUMERALS

- 110: solar battery cell
- 112: photoelectric conversion member
- 114: light incidence surface
- 116: finger electrode
- 120: conductive film
- 130: conductive layer
- 132: thermal-curing resin
- 134: particles
- 140: release layer
- 150: buffering member
- 160: heater head
- 210: non-pressure-bonded region
- 220: pressure-bonded region
- 500: solar battery module
- 518: tab line
- 600: solar battery module
- 610: solar battery cell
- 612: photoelectric conversion member
- 616: finger electrode
- 618: tab line
- 714: bus bar electrode
- 730: conductive layer
- 1300: backing material
- 1312: glass substrate
- 1316: wiring
- 1420: conductive film
- 1460: heater head

## Claims

1. A method for manufacturing an electronic component having a wiring, comprising:
disposing an adhesive film, which is formed by layering an adhesive layer and a release layer, above a substrate having a surface on which the wiring is formed, such that the adhesive layer faces the surface;
cutting the adhesive layer by inserting the wiring into the adhesive layer by depressing the adhesive film to the substrate;
separating one adhesive layer portion of the cut adhesive layer from the surface; and
releasing the release layer from the other adhesive layer portion of the cut adhesive layer.

2. The manufacturing method according to claim 1, wherein
the cutting includes heating the other adhesive layer portion.

3. The manufacturing method according to claim 1 or 2, wherein
the cutting includes heating a vicinity of a region of the adhesive layer that contacts the wiring.

4. The manufacturing method according to any one of claims 1 to 3, wherein
the electronic component is a solar battery module including a photoelectric conversion member that generates photo-generated carriers by receiving incident light, and
the wiring is a finger electrode that collects the photo-generated carriers generated by the photoelectric conversion member.

5. The manufacturing method according to claim 4, further comprising
an electrically connecting step of electrically connecting a tab line and the finger electrode by bonding the tab line to the other adhesive layer portion from which the release layer has been released.

6. The manufacturing method according to any one of claims 1 to 5, wherein
the adhesive layer has a conductive property.

7. A method for coating an adhesive layer, comprising:
disposing an adhesive film, which is formed by layering the adhesive layer and a release layer, above a substrate having a surface on which a wiring is formed, such that the adhesive layer faces the surface;
cutting the adhesive layer by inserting the wiring into the adhesive layer by depressing the adhesive film to the substrate;
separating one adhesive layer portion of the cut adhesive layer from the surface; and
releasing the release layer from the other adhesive layer portion of the cut adhesive layer.

8. An electronic component, comprising:
a substrate;
a wiring formed on a surface of the substrate; and
an adhesive layer coated on the surface,
wherein
the wiring is formed to have a height from the surface that is larger than a thickness of the adhesive layer, and
the adhesive layer is cut by the wiring.

9. The electronic component according to claim 8, comprising
a plurality of wirings,
wherein
a first wiring of the plurality of wirings is formed to have a height from the surface that is larger than a height of the rest of the plurality of wirings, and
the adhesive layer is coated at one side surface of the first wiring, and is not coated at the other side surface of the first wiring.

10. The electronic component according to claim 9, wherein
the electronic component is a solar battery module,
the substrate includes a photoelectric conversion member which generates photo-generated carriers by receiving incident light,
the plurality of wirings are a plurality of finger electrodes which collect the photo-generated carriers generated by the photoelectric conversion member, and
the adhesive layer contacts at least a portion of each of the plurality of finger electrodes.

11. A conductive film formed by layering a conductive layer and a release layer, wherein
the conductive layer contains a thermal-curing resin and conductive particles, and softens at a temperature between 30 °C and 180 °C and thermally cures at a temperature equal to or higher than 60 °C, and
the conductive film is disposed above a substrate having a surface on which a wiring having a height larger than a thickness of the conductive layer is formed, such that the conductive film straddles the wiring, at least a portion of the conductive layer is softened by being heated, the conductive layer having been softened is cut by letting the wiring be inserted thereinto, one conductive layer portion of the cut conductive layer is separated from the surface, the release layer is released from the other conductive layer portion of the cut conductive layer, and the other conductive layer portion is coated on the surface of the substrate by the other conductive layer portion being thermally cured.
